# EUROPEAN PATENT SPECIFICATION

(11) **EP 4 413 072 B1**
(45) Date of publication and mention of the grant of the patent: **09.04.2025**
(21) Application number: 22800147.5
(22) Date of filing: 30.09.2022
(51) Int. Cl.: C08K 7/04, C08K 7/14, C08K 7/18

(54) **THERMALLY CONDUCTIVE SILICONE COMPOSITION AND METHOD FOR PRODUCING THE SAME**
WÄRMELEITFÄHIGE SILIKONZUSAMMENSETZUNG UND HERSTELLUNGSVERFAHREN DAFÜR
COMPOSITION DE SILICONE THERMOCONDUCTRICE ET SON PROCÉDÉ DE PRODUCTION

(30) Priority: 06.10.2021 JP 2021164861; 25.02.2022 JP 2022027407; 01.09.2022 JP 2022139045
(43) Date of publication of application: 14.08.2024
(73) Proprietor: Wacker Chemie AG, 81671 München (DE)
(72) Inventor: YAMADA, Shunsuke, Chikusei-shi, Ibaraki 300--4522 (JP); SAKAI, Kazuya, Chikusei-shi, Ibaraki 300--4522 (JP)
(74) Representative: Mieskes, Klaus Theoderich
(86) International application number: PCT/EP2022/077374
(87) International publication number: WO 2023/057347

(56) References cited:
- CN-A- 108 129 847
- US-A1- 2015 183 960
- US-A1- 2019 092 993

## Description

### TECHNICAL FIELD

The present invention relates to a thermally conductive silicone composition that contains a thermally conductive filler and has heat dissipation and insulation properties.

### BACKGROUND ART

A thermally conductive silicone composition (gap filler) is directly applied to a heat generating body or a heat dissipating body to transfer heat generated from batteries in electric automobiles or semiconductors in electronic devices, which generate heat, to a heat dissipating member such as a heat sink. As to the application method, the gap filler can be applied in a constant amount at a predetermined position by a dispenser. Therefore, the gap filler needs to have flowability suitable for discharge by such a dispenser.

In this case, when the viscosity of the gap filler is too high, dispensing properties deteriorate, so that a required amount of the gap filler cannot be discharged within a limited time, resulting in reduced production efficiency. The gap filler is compressed to maintain a predetermined gap between the heat generating body and the heat dissipating body. However, when the amount of thermally conductive fillers is large at that time, an extra force is required for compressing, and excess stress may damage an electronic board and the like.

In contrast, when the viscosity of the gap filler is too low, dispensing properties are improved, but cut stringiness deteriorates. Thus, it is difficult for the gap filler to be dispensed in a constant amount at a predetermined position. When a gap of a portion where the gap filler is discharged is wide, the gap cannot be filled with the gap filler due to draining (pumping out) after discharge of the gap filler. This is also a problem. Thus, the shape retentivity in terms of height after application is required. When the amount of thermally conductive fillers added is decreased, the thermal conductivity of the entire gap filler deteriorates, and sufficient heat dissipation performance cannot be exerted.

To solve these problems, a method of improving thixotropic properties by increasing the amount of fine fillers is generally used. However, this measure may increase its viscosity to cause a problem in which crushing properties and dispensing properties deteriorate. When the amount of the fillers is not sufficiently increased, a heat dissipation effect is insufficient. However, an increase in the amount of the fillers is not preferred since the specific gravity is increased.

When the gap filler is used for electronic boards or an insulation state needs to be maintained with reliability between a heat generating body and a heat dissipating member, insulation properties are required for the gap filler. In this case, metal particles of aluminum, copper, or silver cannot be used as a thermally conductive filling material, but a thermally conductive insulating filling material such as aluminum hydroxide or alumina (aluminum oxide) is frequently used. Aluminum hydroxide and alumina have low thermal conductivity in themselves. Therefore, it is necessary that a large amount of aluminum hydroxide or alumina be used in filling to obtain a thermally conductive material having high thermal conductivity. This may cause problems in which the viscosity of the thermally conductive material becomes very high to hinder the application thereof, and the thermally conductive material cannot be compressed sufficiently, and have increased specific gravity.

Patent Literature 1 discloses, as a thermally conductive insulating silicone composition, a composition containing aluminum nitride as a thermally conductive filler. Patent Literature 1 describes that the composition has high thermal conductivity and compressive properties, and that when the viscosity of the composition falls within a predetermined range, shape retention and discharge are easy, and workability is favorable.

However, the composition has low viscosity. Therefore, cut stringiness and shape retentivity are insufficient, and the shape retentivity of the gap filler needs to be further improved.

Patent literature 2 is in the same field as the present application and discloses thermally conductive silicone compositions that can be used in the same context. In its example 4 it discloses such a composition comprising polysiloxane oils respectively having reactive vinyl or hydrogen groups, a hydrosilylation catalyst and alumina as well as glass fibers.

### CITATION LIST

### PATENT LITERATURE

Patent Literature 1: Japanese Patent Application Laid-open No. 2020-169231
Patent Literature 2: CN 108 129 847 A

### SUMMARY OF INVENTION

### TECHNICAL PROBLEM

Under such circumstances, development of a thermally conductive insulating silicone composition that can achieve favorable cut stringiness and high shape retentivity in addition to favorable dispensing properties and crushing properties is desired. The present invention has been made in view of the circumstances, and an object of the present invention is to provide a thermally conductive insulating silicone composition that has more favorable dispensing properties and crushing properties than a conventional thermally conductive silicone composition and also has high shape retentivity, and also to provide a method for producing the same.

### SOLUTION TO PROBLEM

The inventors of the present invention have found that, when in a thermally conductive silicone composition containing an organopolysiloxane, a thermally conductive fibrous inorganic filler and a thermally conductive spherical filler or a thermally conductive amorphous filler are added, the problems of the present invention can be solved. Thus, the inventors have completed the present invention.

That is, the present invention is a thermally conductive silicone composition including:
a component (A) that is a diorganopolysiloxane having an alkenyl group bonded to a silicon atom, with a viscosity, at 25°C, of 10 mPa·s or more and 1,000,000 mPa·s or less;
a component (B) that is a diorganopolysiloxane having a hydrogen atom bonded to a silicon atom, with a viscosity, at 25°C, of 10 mPa·s or more and 1,000,000 mPa·s or less;
a component (C) that is a thermally conductive fibrous inorganic filler;
a component (D) that is a thermally conductive spherical filler or a thermally conductive amorphous filler; and
a component (E) that is an addition catalyst.

Here, the thermally conductive silicone composition is applied in a liquid state to a substrate.

### ADVANTAGEOUS EFFECTS OF INVENTION

The composition of the present invention has favorable dispensing properties and crushing properties and also has high shape retentivity, and thus, is useful as a thermally conductive silicone composition, such as a gap filler, that is directly applied in a liquid state to a substrate by using a dispenser or the like.

### DESCRIPTION OF EMBODIMENTS

Hereinafter, a thermally conductive silicone composition, a method for producing the thermally conductive silicone composition, and a method for improving properties of the thermally conductive silicone composition according to the present invention will be described in detail. Herein, a filler is also referred to as a filling material.

The thermally conductive silicone composition according to the present invention includes:
a component (A) that is a diorganopolysiloxane having an alkenyl group bonded to a silicon atom, with a viscosity, at 25°C, of 10 mPa·s or more and 1,000,000 mPa·s or less;
a component (B) that is a diorganopolysiloxane having a hydrogen atom bonded to a silicon atom, with a viscosity, at 25°C, of 10 mPa·s or more and 1,000,000 mPa·s or less;
a component (C) that is a thermally conductive fibrous inorganic filler;
a component (D) that is a thermally conductive spherical filler or a thermally conductive amorphous filler; and
a component (E) that is an addition catalyst.

Here, the thermally conductive silicone composition is applied in a liquid state to a substrate or the like.

### Component (A):

The component (A), which is a main component of the thermally conductive silicone composition, is a diorganopolysiloxane having an alkenyl group bonded to a silicon atom, with a viscosity, at 25°C, of 10 mPa·s or more and 1,000,000 mPa·s or less.

As the diorganopolysiloxane, one type thereof may be used alone, or two or more types thereof may be used in combination as appropriate. The diorganopolysiloxane is the main component of the thermally conductive silicone composition (hereinafter which may be simply referred to as a silicone composition) and has at least one alkenyl group bonded to a silicon atom within one molecule on average, preferably 2 to 50 alkenyl groups, and more preferably 2 to 20 alkenyl groups.

The component (A) does not have a specifically limited molecular structure, and may have, for example, a linear structure, a partially branched linear structure, a branched chain structure, a cyclic structure, or a branched cyclic structure. Among these, the component (A) is preferably a substantially linear organopolysiloxane, and specifically preferably a linear diorganopolysiloxane in which the molecular chain is mainly composed of a diorganosiloxane repeat unit and of which both terminals of the molecular chain are blocked with a triorganosiloxy group. Some or all of the molecular chain terminals may be an Si-OH group.

The component (A) may be a polymer composed of a single siloxane unit or a copolymer composed of two or more siloxane units. The position of the alkenyl group bonded to the silicon atom in the component (A) is not particularly limited, and the alkenyl group may be bonded only to the silicon atom at the molecular chain terminal or to the silicon atom at a molecular chain site which is not the terminal (in the middle of the molecular chain), or may be bonded to both.

The viscosity of the component (A) at 25°C is 10 mPa·s or more and 1,000,000 mPa·s or less, preferably 20 mPa·s or more and 500,000 mPa·s or less, and more preferably 50 mPa·s or more and 10,000 mPa·s or less. If the viscosity is too low, the filling materials of the components (C) and (D), to be described later, tend to precipitate in the obtained silicone composition, and there is a concern that long-term storage stability becomes poor. In addition, if the viscosity is too high, the obtained silicone composition tends to have remarkably low fluidity, and there is a possibility that discharge properties are lowered and the productivity deteriorates.

Two or more diorganopolysiloxanes having an alkenyl group and having respective different viscosities can also be used to adjust the viscosity of the final product silicone composition. The viscosity of the silicone composition, which is the final product containing the components (A) to (E) described above, is not particularly limited, and falls, for example, within the range of 50,000 mPa·s or more and 2,000,000 mPa·s or less, and more preferably in the range of 100,000 mPa·s or more and 1,000,000 mPa·s or less.

Specifically, the component (A) is represented by the following general formula (1) as an average composition formula:

R¹ₐSiO_{(4-a)/2} ... (1)

(In the formula (1), R¹s are the same as or different from each other and each are an unsubstituted or substituted monovalent hydrocarbon group of 1 to 18 carbon atoms, and a is 1.7 to 2.1.)

In one embodiment, at least two or more of the monovalent hydrocarbon groups represented by the aforementioned R¹ are selected from alkenyl groups such as a vinyl group, an allyl group, a propenyl group, an isopropenyl group, a butenyl group, an isobutenyl group, a hexenyl group, and a cyclohexenyl group. Groups other than these groups are substituted or unsubstituted monovalent hydrocarbon groups having 1 to 18 carbon atoms. Specifically, it is selected from the group consisting of an alkyl group such as a methyl group, an ethyl group, a propyl group, an isopropyl group, a butyl group, an isobutyl group, a tert-butyl group, a pentyl group, a neopentyl group, a hexyl group, a 2-ethylhexyl group, a heptyl group, an octyl group, a nonyl group, a decyl group, and a dodecyl group; a cycloalkyl group such as a cyclopentyl group, a cyclohexyl group, and a cycloheptyl group; an aryl group such as a phenyl group, a tolyl group, a xylyl group, a biphenyl group and a naphthyl group; an aralkyl group such as a benzyl group, a phenylethyl group, a phenylpropyl group, and a methylbenzyl group; and a halogen-substituted or cyan-substituted alkyl group in which a part or all of hydrogen atoms in the above-described hydrocarbon groups have been substituted with a halogen atom, a cyano group, or the like, such as a chloromethyl group, a 2-bromoethyl group, a 3,3,3-trifluoropropyl group, a 3-chloropropyl group, and a cyanoethyl group.

R¹s to be selected preferably include a vinyl group as the two or more alkenyl groups required, and a methyl group, a phenyl group, or a 3,3,3-trifluoropropyl group as the other groups. In addition, it is preferable that 70 mol% or more of R¹s be a methyl group, in consideration of physical properties and economic efficiency of the cured product, and normally, it is preferable that 80 mol% or more of R¹s be a methyl group.

Specific examples of the molecular structure of the component (A) include a dimethylpolysiloxane with both molecular chain terminals blocked with a dimethylvinylsiloxy group, a dimethylsiloxane-methylphenylsiloxane copolymer with both molecular chain terminals blocked with a dimethylvinylsiloxy group, a dimethylsiloxane-methylvinylsiloxane copolymer with both molecular chain terminals blocked with a dimethylvinylsiloxy group, a dimethylsiloxane-methylvinylsiloxane-methylphyenylsiloxane copolymer with both molecular chain terminals blocked with a dimethylvinylsiloxy group, and a dimethylsiloxane-methylvinylsiloxane copolymer with both molecular chain terminals blocked with a trimethylsiloxy group. Other examples thereof include an organopolysiloxane composed of a siloxane unit represented by the formula: (CH₃)₂ViSiO_{1/2}, a siloxane unit represented by the formula: (CH₃)₃SiO_{1/2}, and a siloxane unit represented by the formula: SiO_{4/2} (Vi in the formula represents a vinyl group), and an organopolysiloxane in which part or all of the methyl groups in the above-mentioned organopolysiloxanes are substituted by an alkyl group such as an ethyl group or a propyl group, an aryl group such as a phenyl group or a tolyl group, and a halogenated alkyl group such as a 3,3,3-trifluoropropyl group, and mixtures of two or more of these organopolysiloxanes. From the viewpoint of enhancing elongation at the time of breakage of the cured product due to increased molecular chain length, a linear diorganopolysiloxane with a vinyl group at both molecular chain terminals is preferable.

These diorganopolysiloxanes may be commercially available or prepared by methods known to those skilled in the art.

The content of the organopolysiloxane of the component (A) relative to 100 parts by mass of the entire silicone composition of the present invention is preferably 0.2% by mass or more and 10.0% by mass or less, and more preferably 1.0% by mass or more and 7.0% by mass or less. When the viscosity falls within the aforementioned range, the viscosity of the entire silicone composition can fall within an appropriate range. Thus, the thermally conductive silicone composition has excellent crushing properties, can suppress a phenomenon in which it flows out after being applied to a substrate, and thus, it is possible to maintain high thermal conductivity due to an appropriate fluidity.

### Component (B):

The component (B) is a diorganopolysiloxane having a hydrogen atom bonded to a silicon atom, with a viscosity, at 25°C, of 10 mPa·s or more and 1,000,000 mPa·s or less.

The component (B) is a diorganopolysiloxane having one or more hydrogen atoms bonded to a silicon atom within one molecule, and serves as a crosslinking agent for curing the silicone composition of the present invention.

The component (B) may be any organohydrogenpolysiloxane as long as it contains one or more hydrogen atoms (SiH groups) bonded to a silicon atom within one molecule. Examples thereof that can be used include a methylhydrogenpolysiloxane, a dimethylsiloxane-methylhydrogensiloxane copolymer, a methylphenylsiloxane-methylhydrogensiloxane copolymer, a cyclic methylhydrogenpolysiloxane, and a copolymer composed of a dimethylhydrogensiloxy unit and an SiO_{4/2} unit. As the component (B), one type thereof may be used alone, or two or more types thereof may be used in combination as appropriate.

The molecular structure of the component (B) is not particularly limited, and may be, for example, a linear, branched, cyclic, or three-dimensional network structure. Specifically, the structure represented by the following average composition formula (2) can be used.

R³ₚH_{q}SiO_{(4-p-q)/2} (2)

(In the formula, R³ is an unsubstituted or substituted monovalent hydrocarbon group excluding an aliphatic unsaturated hydrocarbon group. p is 0 to 3.0, preferably 0.7 to 2.1, q is 0.0001 to 3.0, preferably 0.001 to 1.0, and p + q is a positive number satisfying 0.5 to 3.0, preferably 0.8 to 3.0.)

Examples of R³ in the formula (2) include non-substituted or halogen-substituted monovalent hydrocarbon groups and the like having 1 to 10 carbon atoms, preferably 1 to 8 carbon atoms excluding an aliphatic unsaturated hydrocarbon group. Specific examples thereof include an alkyl group such as a methyl group, an ethyl group, a propyl group, a butyl group, a pentyl group, a hexyl group, an isopropyl group, an isobutyl group, a tert-butyl group, and a cyclohexyl group; an aryl group such as a phenyl group, a tolyl group, and a xylyl group; an aralkyl group such as a benzyl group and a phenethyl group; and an alkyl halide group such as a 3-chloropropyl group and a 3,3,3-trifluoropropyl group. Among these, a methyl group, an ethyl group, a propyl group, a phenyl group, and a 3,3,3-trifluoropropyl group are preferable, and a methyl group is particularly preferable.

Specific examples of the component (B) include 1,1,3,3-tetramethyldisiloxane, 1,3,5,7-tetramethylcyclotetrasiloxane, a methylhydrogencyclopolysiloxane, a methylhydrogensiloxane-dimethylsiloxane cyclic copolymer, tris(dimethylhydrogensiloxy)methylsilane, tris(dimethylhydrogensiloxy)phenylsilane, a dimethylsiloxane-methylhydrogensiloxane copolymer with both molecular chain terminals blocked with a dimethylhydrogensiloxy group, a methylhydrogenpolysiloxane with both molecular chain terminals blocked with a dimethylhydrogensiloxy group, a methylhydrogenpolysiloxane with both molecular chain terminals blocked with a trimethylsiloxy group, a dimethylpolysiloxane with both molecular chain terminals blocked with a dimethylhydrogensiloxy group, a dimethylsiloxane-diphenylsiloxane copolymer with both molecular chain terminals blocked with a dimethylhydrogensiloxy group, a dimethylsiloxane-methylhydrogensiloxane copolymer with both molecular chain terminals blocked with a trimethylsiloxy group, a dimethylsiloxane-diphenylsiloxane-methylhydrogensiloxane copolymer with both molecular chain terminals blocked with a trimethylsiloxy group, a dimethylsiloxane-methylhydrogensiloxane copolymer with both molecular chain terminals blocked with a dimethylhydrogensiloxy group, a copolymer of a H(CH₃)₂SiO_{1/2} unit and an SiO₂ unit, and a copolymer of a H(CH₃)₂SiO_{1/2} unit, a (CH₃)₃SiO_{1/2} unit, and an SiO₂ units, and mixtures of two or more of these organohydrogensiloxanes.

In the silicone composition described above, the content of the component (B) is preferably in such a range that the ratio of the number of SiH groups in the component (B) to the alkenyl group in the component (A) falls within the range of 1/5 to 7, more preferably within the range of 1/2 to 2, and still more preferably within the range of 3/4 to 5/4. When the content of the component (B) falls within the aforementioned range, the silicone composition is sufficiently cured and the hardness of the entire silicone composition becomes a more preferable range, so that cracks are less likely to occur when used as a gap filler. In addition to these, there is an advantage that the silicone composition dose not sag and can maintain its retention ability in the vertical direction even when the substrate is disposed in a vertical orientation.

The SiH group in the component (B) may be bonded to the molecular chain terminals, may be bonded to side chains, or may be bonded to both the molecular chain terminals and the side chains. It is preferable to use a mixture of an organohydrogenpolysiloxane having an SiH group only at the molecular chain terminals and an organohydrogenpolysiloxane having an SiH group only at the side chain of the molecular chain.

The organohydrogenpolysiloxane having an SiH group only at the molecular chain terminals has an advantage that the organohydrogenpolysiloxane has high reactivity due to low steric hindrance, and the organohydrogenpolysiloxane having an SiH group at the side chains contributes to network construction by a crosslinking reaction and thus has an advantage of improving its strength.

From the viewpoint of improving adhesion and heat resistance, the component (B) may include an organohydrogenpolysiloxane having a trimethylsiloxy group at both the molecular chain terminals and at least one aromatic group contained within the molecule. For economic reasons, the aromatic group is more preferably a phenyl group.

The viscosity of the organohydrogenpolysiloxane of the component (B) at 25°C is 10 mPa·s or more and 1,000,000 mPa·s or less, preferably 20 mPa·s or more and 500,000 mPa·s or less, and more preferably 50 mPa·s or more and 10,000 mPa·s or less.

In order to adjust the viscosity of the silicone composition which is a final product, it is also possible to use two or more types of diorganopolysiloxanes having a hydrogen atom and having respective different viscosities.

### Component (C):

The thermally conductive fibrous inorganic filler of the component (C) is a filling material component that improves the thermal conductivity of the silicone composition to improve dispensing properties, crushing properties, and shape retentivity. To obtain a highly-insulating gap filler that is used for an electronic board and the like, it is preferable that as the thermally conductive filler of the component (C), an inorganic material having not only excellent thermal conductivity but also excellent insulation properties be used. A filler having shape anisotropy includes a plate-like filler that is also referred to as a flat or scale-like filler, or a fibrous filler that is also referred to as a rod-like or needle-like filler. The filler of the present invention is a fibrous filler.

Dispensing properties mean flowability or applying properties when the silicone composition in a liquid state is discharged from a container, a cartridge, or the like that is filled with the silicone composition. It is preferable that the silicone composition have higher flowability or applying properties (i.e., favorable dispensing properties) since the silicone composition is easily discharged.

When the silicone composition is discharged from the container or the like, stress is applied to the silicone composition. The fibrous filler having a surface wet by the liquid components (A) and (B) is randomly dispersed in a system containing the components (A) and (B), and then oriented in a stress direction. Therefore, the viscosity in the stress direction is decreased to improve the dispensing properties. Furthermore, the fibrous filler improves the spinnability of the silicone composition.

It is preferable that the filler be an inorganic fiber having thermal conductivity and insulation properties usable for an electronic part and the like to enhance the thermal conductivity of the entire silicone composition.

Examples of the thermally conductive fibrous inorganic filler of the component (C) include glass fibers, wollastonite, potassium titanate, sepiolite, xonotlite, aluminum borate, alumina fibers, ceramic fibers, and basic inorganic fibers typified by basic magnesium sulfate. Basic inorganic fibers are particularly preferably used.

The shape of the component (C) is not particularly limited as long as the component (C) has a fibrous shape. For example, the component (C) that can be used has an aspect ratio (average fiber length/average fiber diameter) falling within the range of 5 or more, preferably 5 to 1,000, more preferably 5 to 100, and particularly preferably 7 to 40. When the aspect ratio falls within the aforementioned range, the silicone composition that has high dispensing properties, crushing properties, and shape retentivity can be obtained.

Herein, a fibrous shape means that the cross section of a fiber has an approximately circular shape, and does not include a scale-like or plate-like shape having a long elliptical or rectangular cross section. Specifically, a fiber having a cross section with a ratio of a major diameter to a minor diameter (major diameter/minor diameter) falling within the range of 1.0/1.0 to 2.0/1.0 is preferably used. The ratio of the major diameter to the minor diameter of a scale-like or plate-like fiber is larger than the aforementioned range. In this case, resistance under application of stress to the silicone composition is increased to decrease dispensing properties, which is a problem.

The average fiber length falls within the range of, for example, 0.5 to 200 µm, preferably 5.0 to 200 µm, and further preferably 5.0 to 100 µm. The average fiber diameter falls within the range of, for example, 0.1 µm or more and less than 10 µm, preferably 0.3 to 1.2 µm, and further preferably 0.5 to 1.0 µm. The fiber diameter and the fiber length are not particularly limited. When the fiber diameter and the fiber length fall within the aforementioned ranges, dispensing properties and shape retentivity are high, and an effect in which the fiber is less likely to be broken is expected.

The average fiber length and the average fiber diameter of the thermally conductive fibrous inorganic filler formed from fibrous basic magnesium sulfate or the like can be calculated from number-average values of fiber length and fiber diameter, respectively, determined by image analysis of an enlarged image obtained by using a scanning electron microscope (SEM).

In the silicone composition of the present invention, the content of the component (C) is preferably 0.1 parts by mass or more and 5.0 parts by mass or less, and more preferably 0.2 parts by mass or more and 2.0 parts by mass or less, relative to 100 parts by mass of the entire silicone composition.

The amount of the thermally conductive fibrous inorganic filler of the component (C) added relative to 100 parts by mass of the total of the component (A) and the component (B) may be 1 part by mass or more and 50 parts by mass or less, preferably 2 parts by mass or more and 30 parts by mass or less, and more preferably 3 parts by mass or more and 15 parts by mass or less. If the content of the component (C) is too small, it becomes difficult to increase the thermal conductivity of the obtained cured product of the silicone composition. If the content of the component (C) is too large, the silicone composition becomes highly viscous, which may make it difficult to uniformly apply the silicone composition.

### Component (D):

The thermally conductive spherical or amorphous filler of the component (D) improves the thermal conductivity of the silicone composition. This is because when the component (C) and the component (D) are used in combination as the thermally conductive filler, thermally conductive spherical or amorphous particles having a small particle diameter are embedded between the large fibrous fillers, and can be filled in a state close to the closest packing, resulting in high thermal conductivity.

In order to obtain a gap filler having high insulation properties for application to an electronic substrate or the like, it is preferable to use a material having excellent insulation properties as well as thermal conductivity as the thermally conductive filler of the component (D).

Examples of the thermally conductive spherical or amorphous fillers of the component (D) include a metal oxide such as aluminum oxide, zinc oxide, magnesium oxide, titanium oxide, silicon oxide, and beryllium oxide; a metal hydroxide such as aluminum hydroxide and magnesium hydroxide; a nitride such as aluminum nitride, silicon nitride, and boron nitride; a carbide such as boron carbide, titanium carbide, and silicon carbide; graphite; a metal such as aluminum, copper, nickel, and silver; and mixtures thereof. In particular, when electrical insulation properties are required for the silicone composition, the component (D) is preferably a metal oxide, a metal hydroxide, a nitride, or a mixture thereof, and it may be an amphoteric hydroxide or an amphoteric oxide. Specifically, it is preferable to use one or more types selected from the group consisting of aluminum hydroxide, boron nitride, aluminum nitride, zinc oxide, aluminum oxide, magnesium oxide, and magnesium hydroxide.

It should be noted that aluminum oxide is an insulating material, has relatively good compatibility with the components (A) and (B), can be industrially selected from a wide variety of particle diameters, is readily available in resources, is relatively inexpensive, and is therefore suitable as the thermally conductive inorganic filler.

The shape of the component (D) should be a spherical shape or an amorphous shape, and in particular, when aluminum oxide is used as the component (D), aluminum oxide with a spherical shape or an amorphous shape is used. Spherical aluminum oxide is α-alumina obtained mainly by high temperature thermal spraying or hydrothermal treatment of alumina hydrate. Herein, the spherical shape may be not only a true spherical shape but also a rounded shape.

The amorphous shape refers to a shape where the aspect ratio of the major diameter/minor diameter of the particle is 2 or more and less than 5, and also a shape what is called a scaly shape.

The spherical shape refers to a shape where the aspect ratio of the major diameter/minor diameter is 1 or more and less than 2.

The average particle diameter of the component (D) falls within the range of 0.1 µm or more and 500 µm or less, more preferably 0.5 µm or more and 200 µm or less, and even more preferably 1.0 µm or more and 100 µm or less. If the average particle diameter is too small, the fluidity of the silicone composition is lowered. If the average particle diameter is too large, the dispensing properties are lowered, and there may occur a problem that the component (D) may be caught in the sliding portion of an application apparatus and may scrape the apparatus. In the present invention, the average particle diameter of the component (D) is defined by D50 (or median diameter) which is a 50% particle diameter in the volume-based cumulative particle size distribution measured by a laser diffraction particle size measuring apparatus.

When at least two types of fillers (the component (C) and the component (D)) each having a different shape are used in combination, particles of the component (D) are embedded between the particles of the component (C) so that the particles of the component (D) can be filled in a state close to the closest packing, resulting in an effect of higher thermal conductivity.

As the component (D), it is also possible to use only spherical fillers or only amorphous fillers, but it is also possible to use both of them in combination. When the thermally conductive spherical filler is used together, the filling properties of the silicone composition can be enhanced. When the thermally conductive spherical filler having an average particle diameter of 40 µm or more is employed, the filling property and the thermal conductivity can be further enhanced. When the spherical and amorphous fillers are used in combination, if the proportion of the thermally conductive spherical filler is 80% by mass or mor relative to 100% by mass of the entire component (D), it is possible to further enhance the thermal conductivity. When a thermally conductive spherical filler having an average particle diameter of 40 µm or more and 70 µm or less and a thermally conductive amorphous filler having an average particle diameter of 3.0 µm or more and 5.0 µm or less are used in combination, it is possible to further enhance the thermal conductivity.

In the silicone composition of the present invention, the content of the component (D) is preferably 75 parts by mass or more and 95 parts by mass or less, and more preferably 80 parts by mass or more and 90 parts by mass or less, relative to 100 parts by mass of the entire silicone composition. When the content of the component (D) falls within the aforementioned range, the silicone composition has sufficient thermal conductivity as a whole. In addition, it is easy to mix the component (D) at the time of mixing, flexibility even after curing can be maintained, and the specific gravity thereof does not become too large. Thus, the silicone composition is more suitable as a gap filler composition for which thermal conductivity and weight reduction are required. If the content of the component (D) is too small, it becomes difficult to sufficiently increase the thermal conductivity of the obtained cured product of the silicone composition. If the content of the component (D) is too large, the silicone composition becomes highly viscous, which may make it difficult to uniformly apply the silicone composition, resulting in a problem that thermal resistance of the composition increases after curing and flexibility decreases.

### Component (E):

The addition catalyst of the component (E) is a catalyst that promotes an addition-curing reaction between an alkenyl group bonded to a silicon atom in the component (A) described above and a hydrogen atom bonded to a silicon atom in the component (B) described above, and is a catalyst known to those skilled in the art. Examples of the component (E) include a platinum group metal such as platinum, rhodium, palladium, osmium, iridium, and ruthenium, and catalysts in which any of the aforementioned metals is supported by a particulate carrying material (for example, activated carbon, aluminum oxide, and silicon oxide).

Specifically, examples of the component (E) include a platinum halide, a platinum-olefin complex, a platinum-alcohol complex, a platinum-alcoholate complex, a platinum-vinylsiloxane complex, dicyclopentadiene-platinum dichloride, cyclooctadiene-platinum dichloride, and cyclopentadiene-platinum dichloride.

In addition, from an economic viewpoint, a metal compound catalyst other than platinum group metals as described above may be used. Examples of the iron catalyst for hydrosilylation include an iron-carbonyl complex catalyst, an iron catalyst having a cyclopentadienyl group as a ligand, an iron catalyst having a terpyridine-based ligand or a combination of a terpyridine-based ligand and a bistrimethylsilylmethyl group, an iron catalyst having a bisiminopyridine ligand, an iron catalyst having a bisiminoquinoline ligand, an iron catalyst having an aryl group as a ligand, an iron catalyst having a cyclic or acyclic olefin group with an unsaturated group, and an iron catalyst having a cyclic or acyclic olefinyl group with an unsaturated group. Other examples thereof include a cobalt catalyst for hydrosilylation, a vanadium catalyst, a ruthenium catalyst, an iridium catalyst, a samarium catalyst, a nickel catalyst, and a manganese catalyst.

The amount of the component (E) added as the concentration of the catalyst metal element falls within the range of preferably 0.5 to 1,000 ppm, more preferably 1 to 500 ppm, and still more preferably 1 to 100 ppm relative to the total mass of the thermally conductive silicone, although an effective amount thereof depending on the curing temperature and curing time desired depending on the use application is used. If the amount added is less than 0.5 ppm, the addition reaction becomes remarkably slow. If the amount added exceeds 1,000 ppm, the cost increases, which is not economically preferable.

In the thermally conductive silicone containing the thermally conductive filler of the present invention, as an additional optional component other than the aforementioned components (A) to (E), a silicone rubber or a conventionally known additive to a gel can be used as long as the object of the present invention is not impaired. Examples of such additives include an organosilicon compound or an organosiloxane (also referred to as a silane coupling agent) that produces silanols by hydrolysis, a condensation catalyst, an adhesive imparting agent, a pigment, a dye, a curing inhibitor, a heat-resistance imparting agent, a flame retardant, an antistatic agent, a conductivity imparting agent, an airtightness improving agent, a radiation shielding agent, an electromagnetic wave shielding agent, a preservative, a stabilizer, an organic solvent, a plasticizer, a fungicide, an organopolysiloxane which contains one hydrogen atom or alkenyl group bonded to a silicon atom within one molecule and which contains no other functional groups, and a non-functional organopolysiloxyane containing neither a hydrogen atom nor an alkenyl group bonded to a silicon atom. As these optional components, one type thereof may be used alone, or two or more types thereof may be used in combination as appropriate.

Examples of the silane coupling agent include an organosilicon compound and an organosiloxane having an organic group such as an epoxy group, an alkyl group, or an aryl group and a silicon atom-bonded alkoxy group within one molecule.

A silanol produced by the hydrolysis can react with and bond with a condensable group (for example, a hydroxyl group, an alkoxy group, an acid group, or the like) present on the surface of a metal substrate or an organic resin substrate. The silanol and the condensable group react and bond with each other by the catalytic effect of the condensation catalyst described later, thereby increasing the degree of the adhesion of the thermally conductive silicone to various substrates.

As necessary, a condensation catalyst may be used together with the silane coupling agent described above. As the condensation catalyst, a compound of a metal selected from magnesium, aluminum, titanium, chromium, iron, cobalt, nickel, copper, zinc, zirconium, tungsten, and bismuth can be used. Metal compounds such as organic acid salts, alkoxides, and chelate compounds, of trivalent aluminum, trivalent iron, trivalent cobalt, divalent zinc, tetravalent zirconium, and trivalent bismuth, are preferably mentioned as examples of the condensation catalysts. Examples thereof include an organic acid such as octylic acid, lauric acid, and stearic acid, an alkoxide such as a propoxide and a butoxide, and a multidentate ligand chelating compound such as catechol, crown ether, a polyvalent carboxylic acid, hydroxy acid, diketone, and keto acid. Here, a plurality of types of ligands may be bonded to one metal. In particular, a compound of zirconium, aluminum, or iron, which is likely to give stable curability even when the addition and use conditions are somewhat different, is preferred. In addition, a more desirable compound is exemplified as a butoxide of zirconium or a trivalent chelate compound of aluminum or iron including multidentate ligands such as a malonic acid ester, an acetoacetic acid ester, an acetylacetone, or a substituted derivative thereof. In the case of a trivalent aluminum or iron metal compound, an organic acid having 5 to 20 carbon atoms, such as octylic acid, may be preferably used, and the polydentate ligand and the organic acid may be bonded to one metal, whose structure is also preferable.

Examples of the aforementioned substituted derivative include those in which a hydrogen atom contained in the compound is substituted with an alkyl group such as a methyl group or an ethyl group, an alkenyl group such as a vinyl group or an allyl group, an aryl group such as a phenyl group, a halogen atom such as a chlorine atom or a fluorine atom, a hydroxyl group, a fluoroalkyl group, an ester group-containing group, an ether-containing group, a ketone-containing group, an amino group-containing group, an amide group-containing group, a carboxylic acid-containing group, a nitrile group-containing group, an epoxy group-containing group, or the like. Furthermore, specific examples thereof include 2,2,6,6-tetramethyl-3,5-heptanedione and hexafluoropentanedione.

Examples of the pigment include titanium oxide, alumina silicic acid, iron oxide, zinc oxide, calcium carbonate, carbon black, a rare earth oxide, chromium oxide, a cobalt pigment, ultramarine, cerium silanolate, aluminum oxide, aluminum hydroxide, titanium yellow, carbon black, barium sulfate, precipitated barium sulfate, and mixtures thereof.

The curing inhibitor has an ability of adjusting the curing rate of the addition reaction, and any curing inhibitor conventionally known in the art can be used as a compound having a curing suppressing effect. Examples thereof include an acetylene-based compound, hydrazines, triazoles, phosphines, and mercaptans. Specific compounds include a phosphorus-containing compound such as triphenylphosphine, a nitrogen-containing compound such as tributylamine tetramethylethylenediamine, and benzotriazole, a sulfur-containing compound, an acetylene-based compound, a compound containing two or more alkenyl groups, a hydroperoxy compound, a maleic acid derivative, and silane and a silicone compound having an amino group.

Specific examples of the curing inhibitors include various "ene-in" systems such as 3-methyl-3-pentene-1-in and 3,5-dimethyl-3-hexene-1-in; an acetylenic alcohol such as 3,5-dimethyl-1-hexin-3-ol, 1-ethynyl-1-cyclohexanol, and 2-phenyl-3-butyn-2-ol; a maleate and a fumarate such as a well-known dialkyl, dialkenyl, and dialkoxyalkyl fumarate and maleate; and those containing cyclovinylsiloxane.

Examples of the heat resistance imparting agent include cerium hydroxide, cerium oxide, iron oxide, fumed titanium dioxide, and mixtures thereof.

As the airtightness improving agent, any agent may be used as long as it has an effect of reducing the air permeability of the cured product, and any organic substance or inorganic substance may be used. Specific examples thereof include a urethane, a polyvinyl alcohol, a polyisobutylene, a isobutylene-isoprene copolymer, talc having a plate-like shape, mica, glass flakes, boehmite, powders of various metal foils and metal oxides, and mixtures thereof.

The composition including the aforementioned components is a thermally conductive silicone composition that is applied to a substrate while maintaining its liquid state. That is, the composition is a liquid having an initial viscosity at 25°C in the range of 50,000 mPa·s or more and 2,000,000 mPa·s or less, and forms a non-flowable reactant within 120 minutes after being applied to a substrate.

The liquid silicone composition having a viscosity within the aforementioned range can be extruded from a container such as a cartridge, a ribbon, or a dispenser, a syringe, and a tube, and applied to a substrate. It is preferable to apply the composition to a substrate using a dispenser with an L-shaped nozzle/needle or the like.

Here, the substrate refers to a heat dissipating portion and a heat generating portion.

In the present invention, the substrate may be made of one or more materials selected from a glass, a metal, a ceramics, and a resin.

Preferable examples of metal substrates to which the thermally conductive silicone composition of the present invention adheres after curing include metal substrates of a metal selected from the group consisting of aluminum, magnesium, iron, nickel, titanium, stainless steel, copper, lead, zinc, molybdenum, and silicon.

Preferable examples of ceramic substrates to which the thermally conductive silicone composition of the present invention adheres after curing include an oxide, a carbide, and a nitride such as aluminum oxide, aluminum nitride, alumina zirconia, zirconium oxide, zinc oxide, barium titanate, lead zirconate titanate, beryllium oxide, silicon nitride, and silicon carbide.

Preferable examples of resin substrates to which the thermally conductive silicone composition of the present invention adheres after curing include resin substrates of a resin selected from the group consisting of a polyester, an epoxy, a polyamide, a polyimide, an ester, a polyacrylamide, an acrylonitrile-butadiene-styrene (ABS), a styrene, a polypropylene, a polyacetal, an acrylic resin, a polycarbonate (PC), a polyethylene terephthalate (PET), a polybutylene terephthalate (PBT), a polyetheretherketone (PEEK), a polymethylmethacrylate (PMMA), and a silicone resin.

In the target products to which the silicone composition is applied, the heat generating portion may be disposed so as to sandwich the silicone composition after the silicone composition is applied to the heat dissipating portion, the heat dissipating portion may be disposed so as to sandwich the silicone composition after the silicone composition is applied to the heat generating portion, or the silicone composition may be injected into a gap created between the heat generating portion and the heat dissipating portion.

The aforementioned thermally conductive silicone composition has a compressive stress of 300 MPa or less and a shape retentivity of 90% or more before curing.

When the compressive stress is 300 MPa or less, dispensing properties and crushing properties are favorable. When the shape retentivity is 90% or more, draining (pumping out) after discharge to the substrate can be suppressed.

Herein, shape retentivity represents a change in height after 30 minutes relative to height (initial height) immediately after the thermally conductive silicone composition is applied in a circular conical shape to the substrate. As the value of the change is closer to 100%, shape retentivity is more favorable.

In the composition described above, the component (A) and the component (B) undergo a crosslinking reaction in the presence of the addition catalyst (E) to give a cured product. The composition should have a thermal conductivity of 1 or more, and more preferably 2 or more. The thermal conductivity of the composition may be 1 or more and 20 or less, and may also be 2 or more and 15 or less. The specific gravity of the composition should be 1.5 or more and 10 or less. Since it tends to be important for a member including a substrate to which the thermally conductive silicone composition is applied (e.g., an electronic device, a battery, or the like) to have reduced weight, the specific gravity of the composition is preferably 5.0 or less, and more preferably 2.9 or less.

Furthermore, the aforementioned composition preferably has certain insulation properties, and specifically, the volume resistivity thereof is preferably 10¹⁰ (Ω·cm) or higher.

The thermally conductive silicone composition according to the present invention is an addition-curable composition and may be a one-component composition or a two-component composition. The one-component composition can have an improved storage property when the composition is designed to be cured by heat or moisture.

The two-component composition can have a further improved storage property without the aforementioned measures, and can be easily designed to be a composition cured at a room temperature (e.g., 25°C). In that case, the silicone composition according to the present invention can be divided into a first liquid and a second liquid, for example, as follows. The first liquid does not contain the component (B) but contains the component (E), and the second liquid contains the component (B) but does not contain the component (E).

For example, the first liquid contains:
the component (A) that is a diorganopolysiloxane having an alkenyl group bonded to a silicon atom, with a viscosity, at 25°C, of 10 mPa·s or more and 1,000,000 mPa·s or less;
the component (C) that is a thermally conductive fibrous inorganic filler;
the component (D) that is a thermally conductive spherical filler or a thermally conductive amorphous filler; and
the component (E) that is an addition catalyst, and
does not contain the component (B) that is a diorganopolysiloxane having a hydrogen atom bonded to a silicon atom, with a viscosity, at 25°C, of 10 mPa·s or more and 1,000,000 mPa·s or less.

The second liquid contains:
the component (A) that is a diorganopolysiloxane having an alkenyl group bonded to a silicon atom, with a viscosity, at 25°C, of 10 mPa·s or more and 1,000,000 mPa·s or less;
the component (B) that is a diorganopolysiloxane having a hydrogen atom bonded to a silicon atom, with a viscosity, at 25°C, of 10 mPa·s or more and 1,000,000 mPa·s or less
the component (C) that is a thermally conductive fibrous inorganic filler; and
the component (D) that is a thermally conductive spherical filler or a thermally conductive amorphous filler; and
does not contain the component (E) that is an addition catalyst.

In order to divide and store the composition as the first liquid and the second liquid, each of these components may be stored in an organic solvent such as toluene, xylene, hexane, or white spirit, or a mixture thereof. Alternatively, the different components may be emulsified using an emulsifying agent and stored as an aqueous emulsion. In particular, in order to prevent problems such as danger of fire due to volatilization of an organic solvent, deterioration of a working environment, and air pollution, it is particularly preferable to use an emulsion emulsified with a solvent-free system or an emulsifier.

The method for producing the thermally conductive silicone composition according to the present invention may be any method known to a person skilled in the art, and is not limited to particular one, and may include steps of mixing the components (A), (B), and (D), then adding the component (C), and further mixing.

An exemplary method for producing the composition includes mixing the components (A), (B), and (D) in advance with a stirrer, or uniformly kneading these components with a high-shear mixer or extruder such as a two-roll mill, a kneader, a pressure kneader, or Ross mixer, a continuous extruder, or the like, to prepare a silicone rubber base, and then adding the component (C) thereto.

The component (E) and other optional components should be ultimately added in the silicone composition and may be mixed with the components (A), (B), and (D), but may also be mixed with the component (C), or may be mixed after mixing the component (C).

When the component (D) and the components (A) and (B) are mixed together, the viscosity of the mixture increases. Mixing the component (C) thereto gives an advantage that the aggregation of the component (C) in the mixture is suppressed and the dispersibility is improved.

Furthermore, since the kneading time after mixing the component (C) can be shortened, it is possible to maintain the fibrous shape without breaking the fibers, and to maintain much higher dispensing properties, crushing properties, and shape retentivity.

Furthermore, the deactivation of the catalyst can be suppressed by shortening the mixing time in a state in which the component (E) and the component (D) coexist.

Furthermore, the present invention is also a method for improving the dispensing properties and shape retentivity of a thermally conductive silicone composition by mixing a thermally conductive fibrous inorganic filler and a thermally conductive spherical or amorphous filler into a liquid organopolysiloxane represented by a mixture of the component (A) and the component (B).

Herein, a mechanism in which the composition according to the present invention solves the problems will be described.

The diorganopolysiloxanes typified by the components (A) and (B) have much lower surface tension than water, general synthetic oil, and the like. Therefore, the diorganopolysiloxanes easily spread on the surfaces of the thermally conductive fillers, and allow the thermally conductive fillers to be completely wet. Due to this effect, the thermally conductive fillers are dispersed in the system containing the components (A) and (B). However, the compatibility of the fillers with the diorganopolysiloxanes is low, and thus, the fillers dispersed once tend to easily aggregate in the diorganopolysiloxanes. This is because an interface energy between the fillers is thermodynamically lower than an interface energy between the fillers and the diorganopolysiloxanes.

The problems about dispensing properties, crushing properties, and shape retentivity can be solved since the composition according to the present invention contains the fibrous filler of the component (C) and the spherical or amorphous filler of the component (D) and an interaction between the components (C) and (D) is more advantageous than an interaction between the components (C) or between the components (D).

The components (C) and (D) that each have a surface wet by the components (A) and (B) form a three-dimensional network due to the interaction between the components (C) and (D), and the three-dimensional network expresses structural viscosity. In this case, the component (C) that is the fibrous filler is oriented in a random direction, and flowability in a static state where stress is not applied is decreased to exert favorable shape retentivity.

However, such a network structure is not based on a chemical bond. Thus, the network structure is easily disintegrated under application of stress, so that the component (C) that is the fibrous filler is oriented in a direction in which the stress is applied. Thus, the component (D) is dispersed around the component (C). As a result, resistance to a flowing direction is decreased under application of stress, and thus, dispensing properties are improved.

The same applies to crushing properties. The component (C) that forms the network in the random direction is oriented in a direction of the stress during crushing, and thus, favorable crushing properties are expressed in which the composition is crushed even by small stress.

A state is changed between the formation of the network structure in this static state and the orientation of the component (C) in a constant direction under application of the stress, that is, disruption and reconstruction of the network structure can be reversibly repeated.

In particular, when the component (C) is a basic inorganic fiber and the component (D) is an amphoteric hydroxide or an amphoteric oxide, the interaction between the components (C) and (D) is higher, and properties such as dispensing properties, crushing properties, and shape retentivity attributed to the formation of the three-dimensional network structure are further significant. Specifically, when the component (C) is a thermally conductive fibrous inorganic filler containing as a main component basic magnesium sulfate and the component (D) is spherical or amorphous alumina, extremely favorable properties are obtained.

Furthermore, the present invention is a method for producing an electronic device including the steps of discharging the thermally conductive silicone composition from a container filled with the thermally conductive silicone composition and applying the thermally conductive silicone composition to at least either a heat generating portion or a heat dissipating portion, and curing the thermally conductive silicone composition at a temperature of 15°C or higher.

The thermally conductive silicone composition according to the present invention has favorable discharge properties since the viscosity thereof is decreased during discharge under application of stress. The thermally conductive silicone composition also has favorable cut stringiness. Therefore, the thermally conductive silicone composition can be easily applied to a substrate (a heat generating portion or the heat dissipating portion). After applying to the substrate, stress is not applied, and favorable shape retentivity is achieved. The composition according to the present invention may be a room temperature-curable composition to be cured at a temperature of 15°C or higher and lower than 40°C, or a heat-curable composition to be cured under heating. In a case of the heat-curable composition, the composition may be heated after applying the composition to the substrate, or the composition may be cured using heat radiation of a heat dissipating member. The temperature during heating and curing may be, for example, 40°C or higher and 200°C or lower. Examples

The present invention will be specifically described on the basis of Examples, but the present invention is not limited to the following Examples. Table 1 shows mixing ratios of components in Examples and Comparative Examples. Table 2 shows evaluation results. Numerical values of the mixing ratios shown in Table 1 are expressed in part by mass.

### Method for producing cured product of thermally conductive silicone:

A first liquid and a second liquid described in each of Examples and Comparative Examples were weighed at a ratio of 1:1, sufficiently mixed by a stirrer, and then degassed by a vacuum pump, to produce each thermally conductive silicone. The thermally conductive silicones were each cured at 23°C for 24 hours so as to obtain a specimen satisfying each evaluation item. As a result, each cured product was obtained.

### Method for measuring hardness:

The first liquid and the second liquid described in each of Examples and Comparative Examples were weighed at a ratio of 1:1, sufficiently mixed by a stirrer, and then degassed by a vacuum pump. The resultant thermally conductive silicone was poured into a columnar press mold having a diameter of 30 mm and a height of 6 mm, and then cured at 100°C for 60 minutes, to obtain each columnar cured product.

An asker C hardness was measured by a hardness tester ("ASKER CL-150LJ" manufactured by Kobunshi Keiki Co., Ltd.) in an environment of 23°C in accordance with Asker C method in The Standard of The Society of Rubber Industry (SRIS 0101). Specifically, the damper height was adjusted so that the distance between the obtained columnar cured product and an indicator was 15 mm, and the damper falling rate was adjusted so that the time when the indicator reached the surface of a sample was 5 seconds. The maximum value when the indicator collided the sample was defined as a measured value of asker C hardness. The asker C hardness was measured three times by the hardness tester, and the average of the measured values was used. In general, as the asker C hardness is smaller, flexibility is higher.

It is preferable that the asker C hardness of the cured product fall within the range of 50 or more and 70 or less.

### Method for measuring specific gravity:

The first liquid and the second liquid described in each of Examples and Comparative Examples were weighed at a ratio of 1:1, sufficiently mixed by a stirrer, and then degassed by a vacuum pump. The resultant thermally conductive silicone was poured into a sheet-shaped press mold having a height of about 10 cm, a width of about 10 cm, and a thickness of 2 mm, and then cured at 100°C for 60 minutes, to obtain each cured product. The specific gravity (density) (g/m³) of the cured product obtained in each of Examples and Comparative Examples was measured in accordance with JIS K 6249.

In a case of application in which weight reduction is important, the specific gravity is preferably 2.9 or less.

### Method for measuring thermal conductivity:

The first liquid and the second liquid described in each of Examples and Comparative Examples were weighed at a ratio of 1:1, sufficiently mixed by a stirrer, and then degassed by a vacuum pump. The resultant thermally conductive silicone was poured into a columnar press mold having a diameter of 30 mm and a height of 6 mm, and then cured at 100°C for 60 minutes, to obtain each columnar cured product. The thermal conductivity of the cured product was measured by a measurement device (TPS-500 manufactured by Kyoto Electronics Manufacturing Co., Ltd.) on the basis of a hot disc method in accordance with ISO 22007-2. A sensor was disposed between two columnar cured products produced as described above, and the thermal conductivity was measured by the measurement device.

The thermal conductivity is preferably 2.0 or more.

### Method for measuring mixing viscosity:

The first liquid and the second liquid described in each of Examples and Comparative Examples were weighed at a ratio of 1:1, and sufficiently mixed by a stirrer, and the viscosity of the mixture was measured at 25°C in accordance with JIS K 7117-2. Specifically, the thermally conductive composition that was uncured was placed between parallel plates having a diameter of 25 mm, and the viscosity thereof was measured at a shear rate of 10 (1/s) and a gap of 0.5 mm by Physica MR 301 manufactured by Anton Paar.

A viscosity of 300 Pa·s or less represents favorable crushing properties.

### Method for evaluating shape retentivity:

The first liquid and the second liquid described in each of Examples and Comparative Examples were weighed at a ratio of 1:1, and sufficiently mixed by a stirrer. The mixture was applied in a circular cone having a bottom diameter of about 5 cm and a height of about 5 cm in an atmosphere of 23°C, and the height immediately after applying (initial height) and the height after 30 minutes were measured. When the initial height is 5 cm and the height after 30 minutes is, for example, 4 cm, the shape retentivity is 80%. A value closer to 100% is judged to be favorable shape retentivity. The shape retentivity is preferably 90% or more.

### Method for measuring conductive properties:

The first liquid and the second liquid described in each of Examples and Comparative Examples were weighed at a ratio of 1:1, sufficiently mixed by a stirrer, and then degassed by a vacuum pump. The resultant thermally conductive silicone was poured into a sheet-shaped press mold having a height of about 10 cm, a width of about 10 cm, and a thickness of 1 mm, and then cured at 100°C for 60 minutes, to obtain each cured product. The volume resistivity was measured as conductive properties in accordance with JIS K 6249. For example, generally having insulation properties refers to a case where the volume resistivity is more than 1 × 10⁹ Ω·cm. In terms of use for an electronic part, it is particularly preferable that a cured product having insulation properties be obtained.

### Method for measuring compressive stress:

The first liquid and the second liquid described in each of Examples and Comparative Examples were weighed at a ratio of 1:1, and sufficiently mixed by a stirrer, and about 60 g of the resultant thermally conductive composition was discharged onto an aluminum disc having a diameter of about 100 mm in an atmosphere of 23°C. An aluminum disc having a diameter of about 100 mm that was the same as described above was attached to an upper compression jig, and the thermally conductive composition on the aluminum disc was compressed by a compression tester. The compressive stress during the compression was measured in accordance with JIS K 6400-2. Specifically, AUTOGRAPH AGS-J manufactured by Shimadzu Corporation was used to compress the thermally conductive composition to 1.0 mm at a rate of fall of 10 mm/min. The stress value at that time was read out. A smaller stress value is judged to be favorable crushing properties.

The stress value is preferably 100 MPa or less, and further preferably 80 MPa or less.

### Method for evaluating cut stringiness:

A dispenser (MPP3 manufactured by Musashi Engineering, Inc.) was charged with the thermally conductive composition, and the thermally conductive composition was applied in a bead having a width of 10 mm and a length of 20 mm by the dispenser from a height of 2.5 mm above an aluminum plate. The thermally conductive composition was discharged at five positions at intervals of 10 mm, and four bead lengths were measured. When the average of the bead lengths is closer to 10 mm, the cut stringiness is judged to be favorable. When the average is closer to 0 mm, cut stringiness is judged to be poor.

Evaluation results are expressed in the following three stages including A (good), B (average), and C (poor).
A: 6 mm or more
B: 2 mm or more and less than 6 mm
C: less than 2 mm

### Method for producing cured product of thermally conductive silicone:

### Example 1

The first liquid and the second liquid described in each of Examples and Comparative Examples were each produced in accordance with each composition shown in Table by the following procedures. The unit of mixing ratio of each component shown in Table is part by mass.

### [First liquid in Example 1]

A diorganopolysiloxane having an alkenyl group as the component (A) and a platinum-divinyl tetramethyldisiloxane complex as the component (E) were each weighed, added, and kneaded at room temperature for 30 minutes with a planetary mixer.

The component (A) was a mixture of 60% of a linear dimethylpolysiloxane having an alkenyl group only at a side chain, with a viscosity of 100 mPa·s and 40% of a linear dimethylpolysiloxane having an alkenyl group only on a terminal, with a viscosity of 1,000 mPa·s. The number of alkenyl groups bonded to silicon atoms within one molecule of the former was 0.5 to 10 on average, and that of the latter was 1 to 10 on average.

Subsequently, a half amount of n-octylethoxysilane that was a silane-coupling agent as an optional component, and as the component (D), a half amount of spherical alumina having an average particle diameter of 42.8 µm and a half amount of amorphous alumina having an average particle diameter of 4 µm that were thermally conductive fillers, and a half amount of zinc oxide (Hakusuitech Ltd., zinc oxide for heat radiation, particle diameter: 20 µm or less) that was a thermally conductive amorphous filler were added and kneaded at room temperature for 15 minutes with the planetary mixer.

As the spherical alumina, spherical alumina DAM-45 available from Denka Co., Ltd. (average particle diameter: 42.8 µm) was used.

As the amorphous alumina, fine particle alumina SA34 available from Nippon Light Metal Company, Ltd. (average particle diameter: 4 µm) was used.

Subsequently, the remaining half amount of n-octylethoxysilane, the remaining half amount of the thermally conductive spherical filler and the remaining half amount of the thermally conductive amorphous filler as the component (D), and a fibrous inorganic filler as the component (C) were added and kneaded at room temperature for 15 minutes with the planetary mixer. Thus, the first liquid was produced.

As the thermally conductive fibrous inorganic filler, MOS-HIGE (registered trademark) (basic magnesium sulfate available from Ube Material Industries, Ltd., needle shape, average fiber length: 15 µm, average fiber diameter: 0.5 µm) was used.

### [Second liquid in Example 1]

A diorganopolysiloxane having an alkenyl group that was the same as that in the first liquid as the component (A), a diorganopolysiloxane having a hydrogen atom as the component (B), and a crosslinking agent as the optional component (H) were each weighed, added, and kneaded at room temperature for 30 minutes in a planetary mixer.

The component (A) was a mixture of 60% of a linear dimethylpolysiloxane having an alkenyl group only at a side chain, with a viscosity of 100 mPa·s and 40% of a linear dimethylorganopolysiloxane having an alkenyl group only at a terminal, with a viscosity of 1,000 mPa·s. The number of alkenyl groups bonded to silicon atoms within one molecule of the former was 0.5 to 10 on average, and that of the latter was 1 to 10 on average.

The component (B) was a mixture of 80% of a linear dimethylhydrogenpolysiloxane having an SiH group only at a side chain, with a viscosity of 100 mPa·s and 20% of a linear dimethylhydrogenpolysiloxane having an SiH group only at a terminal, with a viscosity of 500 mPa·s. The number of hydrogen atoms bonded to silicon atoms within one molecule of the former was 0.1 to 5 on average, and that of the latter was 1 to 20 on average.

The crosslinking agent was a dimethylpolysiloxane having a hydrogen atom bonded to a silicon atom only at a side chain, with a viscosity of 200 mPa·s.

Subsequently, a half amount of n-octylethoxysilane, and as the component (D), a half amount of spherical alumina having an average particle diameter of 42.8 µm and a half amount of amorphous alumina having an average particle diameter of 4 µm that were thermally conductive fillers, and a half amount of zinc oxide (Hakusuitech Ltd., zinc oxide for heat radiation, particle diameter: 20 µm or less) that was another thermally conductive amorphous filler were added and kneaded at room temperature for 15 minutes with the planetary mixer.

Subsequently, the remaining half amount of n-octylethoxysilane, the remaining half amount of the thermally conductive spherical filler and the remaining half amount of the thermally conductive amorphous filler as the component (D), and a thermally conductive fibrous inorganic filler that was the same as described above as the component (C) were added and kneaded at room temperature for 15 minutes with the planetary mixer. Thus, the second liquid in each of Comparative Examples and Examples was produced.

### (Example 2)

A first liquid and a second liquid were prepared by the same method as that in Example 1 except that the added amounts of the fibrous inorganic filler and the thermally conductive amorphous filler were changed.

### (Example 3)

A first liquid and a second liquid were prepared by the same method as that in Example 2 except that the added amount of the thermally conductive amorphous filler was changed and spherical alumina having an average particle diameter of 74.6 µm was used as the thermally conductive spherical filler.

As the spherical alumina, spherical alumina DAM-70 (average particle diameter: 74.6 µm) manufactured by Denka Co. Ltd. was used.

### (Example 4)

A first liquid and a second liquid were prepared by the same method as that in Example 2, except that the added amount of the thermally conductive amorphous filler was changed and glass fibers were used as the thermally conductive fibrous inorganic filler.

As the glass fiber, a cut fiber SS-10-420 (having an average fiber diameter of 10 µm and an average fiber length of 0.3 mm) manufactured by Nitto Boseki Co., Ltd. was used.

### (Example 5)

A first liquid and a second liquid were prepared by the same method as that in Example 2, except that the thermally conductive amorphous filler was not added and the amount of the thermally conductive spherical filler was increased.

### (Example 6)

A first liquid and a second liquid were prepared by the same method as that in Example 2, except that the thermally conductive spherical filler was not added and the amount of the thermally conductive amorphous filler was increased.

### (Example 7)

A first liquid and a second liquid were prepared by the same method as that in Example 2 except that amorphous aluminum hydroxide was used as the thermally conductive amorphous filler.

As the amorphous aluminum hydroxide, B703 (average particle diameter: 3 µm) manufactured by Nippon Light Metal Co., Ltd. was used.

### (Comparative Example 1)

A first liquid and a second liquid were prepared by the same method as that in Example 2 except that the thermally conductive fibrous inorganic filler was not added.

### (Comparative Example 2)

A first liquid and a second liquid were prepared by the same method as that in Comparative Example 1 except that the added amount of amorphous alumina was increased.

### (Comparative Example 3)

A first liquid and a second liquid were prepared by the same method as that in Comparative Example 2 except that the added amount of amorphous alumina was further increased.

### (Comparative Example 4)

A first liquid and a second liquid were prepared by the same method as that in Comparative Example 1 except that the thermally conductive spherical filler was changed from spherical alumina DAM-45 (average particle diameter: 42.8 µm) manufactured by Denka Co. Ltd. to spherical alumina DAM-70 (average particle diameter: 74.6 µm) manufactured by Denka Co. Ltd.

### (Comparative Example 5)

A first liquid and a second liquid were prepared by the same method as that in Example 2 except that carbon fibers were added in place of the thermally conductive fibrous inorganic filler.

As the carbon fiber, milled fiber K223HM (average fiber diameter of 11 µm, average fiber length of 0.2 mm) manufactured by Mitsubishi Chemical Corp. was used.

The evaluation results are as shown in Table 1.

In Example 1, cut stringiness was good, crushing properties were good due to a low compressive stress of 80 MPa or less, and dispensing properties were also good due to a sufficiently low viscosity of 140 Pa·s. The shape retentivity was 95%, which was very good.

In Example 2, cut stringiness, crushing properties, and dispensing properties were good. Further improvement in shape retentivity as compared with Example 1 is estimated to be based on an effect obtained by increasing the added amount of the thermally conductive fibrous inorganic filler.

In Example 3, crushing properties were better than that in Example 2, and hardness was slightly increased. This is estimated to be based on an effect obtained by increasing the average particle diameter of the thermally conductive spherical fillers.

In Example 4, cut stringiness, crushing properties, and dispensing properties were good. The viscosity was slightly higher than that in Example 2, and the thermal conductivity was slightly decreased. This is estimated to be based on an effect obtained by using glass fibers as the thermally conductive fibrous inorganic filler.

In Example 5, the thermally conductive amorphous filler was not added. Cut stringiness and crushing properties were good, and shape retentivity was slightly lower than that in Example 2.

In Example 6, the thermally conductive spherical filler was not added. As a result, the viscosity was slightly increased, dispensing properties were slightly decreased, and crushing properties were slightly decreased.

In Example 7, amorphous aluminum hydroxide was used. In this case, cut stringiness, shape retentivity, crushing properties, and dispensing properties were also good.

In Comparative Examples 1 to 4, the thermally conductive fibrous filler was not contained, and thus cut stringiness was poor, and the shape retentivity was low (less than 90%). When cut stringiness and shape retentivity are poor regardless of low viscosity and good dispensing properties, the performance of gap filler is not sufficient.

In Comparative Examples 2 and 3, the amount of the thermally conductive amorphous filler was increased for improvement. However, cut stringiness was not improved. Although shape retentivity was slightly improved due to an increase in amount of the amorphous filler, the improvement was insufficient, and crushing properties were decreased. In Comparative Example 3, the hardness value was higher than other Examples and Comparative Examples. Thus, this composition may damage a substrate and the like. Therefore, it is decided that an increase in the amount of the amorphous filler does not achieve the improvement.

Comparative Example 5 is an example in which the thermally conductive spherical filler is added for improvement. However, cut stringiness was not improved, and shape retentivity was lower than that in Comparative Example 1.

In Comparative Example 6, carbon fibers that were a thermally conductive fibrous filler were added. Thus, cut stringiness and shape retentivity were good. However, the carbon fibers have high volume resistivity and low insulation properties, and thus the carbon fibers are not suitable for use in a thermally conductive filler requiring insulation properties.

**[Table 1]**

| | | | Example 1 | Example 2 | Example 3 | Example 4 | Example 5 | Example 6 | Example 7 | Comparative Example 1 | Comparative Example 2 | Comparative Example 3 | Comparative Example 4 | Comparative Example 5 |
|---|---|---|---|---|---|---|---|---|---|---|---|---|---|---|
| First Liquid Mixing Ratio (Parts By Mass) | | | | | | | | | | | | | | |
| Component (A) | Diorganopolysiloxane Having Alkenyl Group | | **12** | **12** | **12** | **12** | **12** | **12** | **12** | **12** | **12** | **12** | **12** | **12** |
| | n-Octyltriethoxysilane | | **0.3** | **0.3** | **0.3** | **0.3** | **0.3** | **0.3** | **0.3** | **0.3** | **0.3** | **0.3** | **0.3** | **0.3** |
| Component (E) | Addition Catalyst | Platinum Complex | **0.2** | **0.2** | **0.2** | **0.2** | **0.2** | **0.2** | **0.2** | **0.2** | **0.2** | **0.2** | **0.2** | **0.2** |
| Component (C) | Thermally Conductive Fibrous Inorganic Filler | MOS-HIGE | **0.5** | **1** | **1** | | **1** | **1** | **1** | | | | | |
| | | Glass Fiber | | | | **1** | | | | | | | | |
| | | Carbon Fiber | | | | | | | | | | | | 1 |
| Component (D) | Thermally Conductive Spherical Or Amorphous Filler | Amorphous Alumina (4 µm) | **40** | **40.5** | **39.5** | **39.5** | | **69.5** | | **40.5** | **42** | **44** | **40** | **39.5** |
| | | Amorphous Alumina (42.8 µm) | **30** | **30** | | **30** | **69.5** | | **30** | **30** | **28.5** | **26.5** | | **30** |
| | | Amorphous Alumina (74.6 µm) | | | **30** | | | | | | | | **30.5** | |
| | | Amorphous Aluminum Hydroxide (3 µm) | | | | | | | **39.5** | | | | | |
| | | Zinc Oxide | **17** | **17** | **17** | **17** | **17** | **17** | **17** | **17** | **17** | **17** | **17** | **17** |
| Sum Total | | | **100** | **101** | **100** | **100** | **100** | **100** | **100** | **100** | **100** | **100** | **100** | **100** |

| | | | Example 1 | Example 2 | Example 3 | Example 4 | Example 5 | Example 6 | Example 7 | Comparative Example 1 | Comparative Example 2 | Comparative Example 3 | Comparative Example 4 | Comparative Example 5 |
|---|---|---|---|---|---|---|---|---|---|---|---|---|---|---|
| Second Liquid Mixing Ratio (Parts By Mass) | | | | | | | | | | | | | | |
| Component (A) | Diorganopolysiloxane Having Alkenyl Group | | **6** | **6** | **6** | **6** | **6** | **6** | **6** | **6** | **6** | **6** | **6** | **6** |
| Component (B) | Diorganopolysiloxane Having Hydrogen Atom | | **3** | **3** | **3** | **3** | **3** | **3** | **3** | **3** | **3** | **3** | **3** | **3** |
| | n-Octyltriethoxysilane | | **0.3** | **0.3** | **0.3** | **0.3** | **0.3** | **0.3** | **0.3** | **0.3** | **0.3** | **0.3** | **0.3** | **0.3** |
| | Crosslinking Agent | | **0.2** | **0.2** | **0.2** | **0.2** | **0.2** | **0.2** | **0.2** | **0.2** | **0.2** | **0.2** | **0.2** | **0.2** |
| Component (C) | Thermally Conductive Fibrous Inorganic Filler | MOS-HIGE | **0.5** | **1** | **1** | | **1** | **1** | **1** | | | | | |
| | | Glass Fiber | | | | **1** | | | | | | | | |
| | | Carbon Fiber | | | | | | | | | | | | **1** |
| Component (D) | Thermally Conductive Spherical Or Amorphous Filler | Amorphous Alumina (4 µm) | **40** | **39.5** | **39.5** | **39.5** | | **69.5** | | **40.5** | **42** | **44** | **40** | **39.5** |
| | | Spherical Alumina (42.8 µm) | **30** | **30** | | **30** | **69.5** | | **30** | **30** | **28.5** | **26.5** | | **30** |
| | | Spherical Alumina (74.6 µm) | | | **30** | | | | | | | | **30.5** | |
| | | Amorphous Aluminum Hydroxide (3 µm) | | | | | | | **39.5** | | | | | |
| | | Zinc Oxide | **17** | **17** | **17** | **17** | **17** | **17** | **17** | **17** | **17** | **17** | **17** | **17** |
| Sum Total | | | **97** | **97** | **97** | **97** | **97** | **97** | **97** | **97** | **97** | **97** | **97** | **97** |

**[Table 2]**

| Test Item | Example 1 | Example 2 | Example 3 | Example 4 | Example 5 | Example 6 | Example 7 | Comparative Example 1 | Comparative Example 2 | Comparative Example 3 | Comparative Example 4 | Comparative Example 5 |
|---|---|---|---|---|---|---|---|---|---|---|---|---|
| Asker C Hardness | 52 | 53 | 57 | 53 | 50 | 58 | 52 | 54 | 56 | 60 | 55 | 53 |
| Specific Gravity | 2.88 | 2.87 | 2.73 | 2.8 | 2.87 | 2.87 | 2.70 | 2.91 | 2.93 | 2.95 | 2.91 | 2.8 |
| Thermal Conductivity | 2.21 | 2.22 | 2.28 | 2 | 2.1 | 2.1 | 2.15 | 2.20 | 2.21 | 2.21 | 2.35 | 2.2 |
| Mixing Viscosityv (Pa·s) | 140 | 187 | 161 | 200 | 120 | 230 | 160 | 100 | 115 | 131 | 85 | 200 |
| Shape Retentivity (%) | 95 | 100 | 100 | 98 | 90 | 100 | 96 | 72 | 78 | 85 | 70 | 98 |
| Volume Resistivity (Ω·cm) | >10^10 | >10^10 | >10^10 | >10^10 | >10^10 | >10^10 | >10^10 | >10^10 | >10^10 | >10^10 | >10^10 | 10^7 |
| Compressive Stress (MPa) | 80 | 81 | 74 | 82 | 72 | 100 | 82 | 78 | 90 | 101 | 73 | 82 |
| Thread Breakage | A | A | A | A | A | A | A | C | C | C | C | A |

### Example 8

A first liquid and a second liquid were produced by the same method as that in Example 2 except that a linear dimethylpolysiloxane having an alkenyl group only at both terminals, with a viscosity of 150 mPa·s as the component (A), and a linear dimethylhydrogenpolysiloxane having an SiH group only at both terminals, with a viscosity of 150 mPa·s as the component (B) were added, zinc oxide was not added, and spherical alumina having an average particle diameter of 42.8 µm and amorphous aluminum hydroxide having an average particle diameter of 3 µm as thermally conductive fillers were added.

A diorganopolysiloxane having an alkenyl group as the component (A), a diorganopolysiloxane having a hydrogen atom as the component (B), and a crosslinking agent as the optional component (H) were each weighed, added, and kneaded at room temperature for 30 minutes with a planetary mixer.

The crosslinking agent was a dimethylpolysiloxane having a hydrogen atom bonded to a silicon atom only at a side chain, with a viscosity of 200 mPa·s.

Subsequently, a half amount of n-octylethoxysilane, and as the component (D), a half amount of spherical alumina having an average particle diameter of 42.8 µm and a half amount of amorphous aluminum hydroxide that were thermally conductive fillers were added and kneaded at room temperature for 15 minutes with the planetary mixer.

Subsequently, the remaining half amount of n-octylethoxysilane, the remaining half amount of the thermally conductive spherical filler and the remaining half amount of the thermally conductive amorphous filler as the component (D), and a thermally conductive fibrous inorganic filler that was as described above as the component (C) were added and kneaded at room temperature for 15 minutes with the planetary mixer. Thus, the second liquid in each of Comparative Examples and Examples was produced.

The results in Examples 8 to 10 and Comparative Example 6 are shown in Table 3.

### (Example 9)

A first liquid and a second liquid were prepared by the same method as that in Example 8 except that amorphous alumina having an average particle diameter of 4 µm was added.

### (Example 10)

A first liquid and a second liquid were prepared by the same method as that in Example 8 except that spherical alumina having an average particle diameter of 74.8 µm was used as the thermally conductive spherical filler.

### (Comparative Example 6)

A first liquid and a second liquid were prepared by the same method as that in Example 8 except that the thermally conductive fibrous inorganic filler was not added.

The results in Examples 8 to 10 are as shown in Table. Cut stringiness and shape retentivity were good, and other physical properties were also good.

In Comparative Example 6, cut stringiness and shape retentivity were lower than those in Example 8 in which the thermally conductive fibrous inorganic filler was added.

**[Table 3]**

| | | | Example 8 | Example 9 | Example 10 | Comparative Example 6 |
|---|---|---|---|---|---|---|
| First Liquid Mixing Ratio (Parts By Mass) | | | | | | |
| Component (A) | Diorganopolysiloxane Having Alkenyl Group | | **12** | **12** | **12** | **12** |
| | n-Octyltriethoxysilane | | **0.3** | **0.3** | **0.3** | **0.3** |
| Component (E) | Addition Catalyst | Platinum Complex | **0.2** | **0.2** | **0.2** | **0.2** |
| Component (C) | Thermally Conductive Fibrous Inorganic Filler | MOS-HIGE | **1** | **1** | **1** | |
| Component (D) | Thermally Conductive Spherical Or Amorphous Filler | Amorphous Alumina (4 µm) | | **10** | **10** | |
| | | Spherical Alumina (42.8 µm) | **25** | **15** | | **25** |
| | | Spherical Alumina (74.6 µm) | | | **15** | |
| | | Amorphous Aluminum Hydroxide (3 µm) | **61.5** | **61.5** | **61.5** | **62.5** |
| Sum Total | | | **100** | **100** | **100** | **100** |

| Second Liquid Mixing Ratio (Parts By Mass) | | | | | | |
|---|---|---|---|---|---|---|
| Component (A) | Diorganopolysiloxane Having Alkenyl Group | | **6** | **6** | **6** | **6** |
| Component (B) | Diorganopolysiloxane Having Hydrogen Atom | | **3** | **3** | **3** | **3** |
| | n-Octyltriethoxysilane | | **0.3** | **0.3** | **0.3** | **0.3** |
| Component (H) | Crosslinking Agent | | **0.2** | **0.2** | **0.2** | **0.2** |
| Component (C) | Thermally Conductive Fibrous Inorganic Filler | MOS-HIGE | **1** | **1** | **1** | |
| | | Carbon Fiber | | | | |
| Component (D) | Thermally Conductive Spherical Or Amorphous Filler | Amorphous Alumina 4 µm | | **10** | **10** | |
| | | Spherical Alumina (42.8 µm) | **25** | **15** | | **25** |
| | | Spherical Alumina (74.6 µm) | | | **15** | |
| | | Amorphous Aluminum Hydroxide (3 µm) | **61.5** | **61.5** | **61.5** | **62.5** |
| Sum Total | | | **97** | **97** | **97** | **97** |

**[Table 4]**

| Test Item | Example 8 | Example 9 | Example 10 | Comparative Example 6 |
|---|---|---|---|---|
| Asker C Hardness | 54 | 50 | 50 | 50 |
| Specific Gravity | 2.84 | 2.85 | 2.84 | 2.85 |
| Thermal Conductivity | 2.20 | 2.20 | 2.20 | 2.20 |
| Mixing Viscosity (Pa·s) | 142 | 156 | 155 | 135 |
| Shape Retentivity (%) | 98 | 100 | 100 | 70 |
| Volume Resistivity (Ω·cm) | >10^10 | >10^10 | >10^10 | >10^10 |
| Compressive Stress (MPa) | 68 | 77 | 80 | 66 |
| Thread Breakage | A | A | A | C |

## Claims

1. A thermally conductive silicone composition having a compressive stress of 300 MPa or less and a shape retentivity of 90% or more and an initial viscosity at 25°C in the range of 50,000 mPa·s or more and 2,000,000 mPa·s or less, wherein the compressive stress, the shape retentivity and the initial viscosity are measured as disclosed in the description, and comprising:
a component (A) that is a diorganopolysiloxane having an alkenyl group bonded to a silicon atom, with a viscosity, at 25°C, of 10 mPa·s or more and 1,000,000 mPa·s or less, wherein the viscosity is measured as disclosed in the description;
a component (B) that is a diorganopolysiloxane having a hydrogen atom bonded to a silicon atom, with a viscosity, at 25°C, of 10 mPa·s or more and 1,000,000 mPa·s or less;
0.1 parts by mass or more and 5.0 parts by mass or less relative to 100 parts by mass of the entire silicone composition of a component (C) that is a thermally conductive fibrous inorganic filler which is a basic inorganic fiber;
75 parts by mass or more and 95 parts by mass or less relative to 100 parts by mass of the entire silicone composition of a component (D) that is a thermally conductive spherical filler or a thermally conductive amorphous filler and includes one selected from the group consisting of aluminum hydroxide, boron nitride, aluminum nitride, zinc oxide, aluminum oxide, magnesium oxide, and magnesium hydroxide or is an amphoteric hydroxide or an amphoteric oxide; and
a component (E) that is an addition catalyst, wherein
the thermally conductive silicone composition is suitable to be applied in a liquid state to a substrate, on which it forms a non-flowable reactant within 120 minutes after being applied.

2. The thermally conductive silicone composition according to claims 1, wherein the thermally conductive fibrous inorganic filler of the component (C) is basic magnesium sulfate.

3. The thermally conductive silicone composition according to any one of claims 1 to 2, wherein the thermally conductive fibrous inorganic filler of the component (C) has an average fiber diameter of 0.1 µm or more and less than 10 µm, and an average fiber length of 0.5 µm or more and 200 µm or less.

4. The thermally conductive silicone composition according to any one of claims 1 to 3, wherein the thermally conductive fibrous inorganic filler of the component (C) is contained in an amount of 1 part by mass or more and 50 parts by mass or less relative to 100 parts by mass of a total amount of the component (A) and the component (B).

5. A method for producing the thermally conductive silicone composition according to any one of claims 1 to 4, comprising the step of adding and mixing the component (C) after mixing the components (A), (B), and (D).

6. A method for improving dispensing properties and shape retentivity of the thermally conductive silicone composition according to any one of claims 1 to 4 by mixing a thermally conductive fibrous inorganic filler (C) and a thermally conductive spherical or amorphous filler (D) into a liquid organopolysiloxane represented by a mixture of the component (A) and the component (B).

7. A method for producing an electronic device comprising the steps of:
discharging the thermally conductive silicone composition according to any one of claims 1 to 4 from a container filled with the thermally conductive silicone composition and applying the thermally conductive silicone composition to at least either a heat generating portion or a heat dissipating portion; and
curing the thermally conductive silicone composition at a temperature of 15°C or higher.

## Patentansprüche

1. Wärmeleitfähige Siliconzusammensetzung mit einer Druckspannung von 300 MPa oder weniger und einer Formbeständigkeit von 90 % oder mehr und
einer Anfangsviskosität bei 25 °C in dem Bereich von 50.000 mPa·s oder mehr und 2.000.000 mPa·s oder weniger, wobei die Druckspannung, die Formbeständigkeit und die Anfangsviskosität wie in der Beschreibung offenbart gemessen werden, und umfassend:
eine Komponente (A), die ein Diorganopolysiloxan mit einer an ein Siliciumatom gebundenen Alkenylgruppe ist, mit einer Viskosität bei 25 °C von 10 mPa·s oder mehr und 1.000.000 mPa·s oder weniger, wobei die Viskosität wie in der Beschreibung offenbart gemessen wird;
eine Komponente (B), die ein Diorganopolysiloxan mit einem an ein Siliciumatom gebundenen Wasserstoffatom ist, mit einer Viskosität bei 25 °C von 10 mPa·s oder mehr und 1.000.000 mPa·s oder weniger;
0,1 Masseteile oder mehr und 5,0 Masseteile oder weniger bezogen auf 100 Masseteile der gesamten Siliconzusammensetzung an einer Komponente (C), die ein wärmeleitfähiger faserförmiger anorganischen Füllstoff ist, der eine basische anorganische Faser ist;
75 Masseteile oder mehr und 95 Masseteile oder weniger bezogen auf 100 Masseteile der gesamten Siliconzusammensetzung an einer Komponente (D), die ein wärmeleitfähiger sphärischer Füllstoff oder ein wärmeleitfähiger amorpher Füllstoff ist
und eines ausgewählt aus der Gruppe bestehend aus Aluminiumhydroxid, Bornitrid, Aluminiumnitrid, Zinkoxid, Aluminiumoxid, Magnesiumoxid und Magnesiumhydroxid umfasst
oder ein amphoteres Hydroxid oder ein amphoteres Oxid ist; und
eine Komponente (E), die ein Additionskatalysator ist, wobei die wärmeleitfähige Siliconzusammensetzung geeignet ist, in einem flüssigen Zustand auf ein Substrat aufgebracht zu werden, auf dem sie innerhalb von 120 Minuten nach dem Aufbringen einen nicht fließfähigen Reaktanten bildet.

2. Wärmeleitfähige Siliconzusammensetzung nach Anspruch 1, wobei der wärmeleitfähige faserförmige anorganische Füllstoff der Komponente (C) basisches Magnesiumsulfat ist.

3. Wärmeleitfähige Siliconzusammensetzung nach einem der Ansprüche 1 bis 2, wobei der wärmeleitfähige faserförmige anorganische Füllstoff der Komponente (C) einen mittleren Faserdurchmesser von 0,1 µm oder mehr und weniger als 10 µm und eine mittlere Faserlänge von 0,5 µm oder mehr und 200 µm oder weniger aufweist.

4. Wärmeleitfähige Siliconzusammensetzung nach einem der Ansprüche 1 bis 3, wobei der wärmeleitfähige faserförmige anorganische Füllstoff der Komponente (C) in einer Menge von 1 Masseteil oder mehr und 50 Masseteile oder weniger bezogen auf 100 Masseteile einer Gesamtmenge der Komponente (A) und der Komponente (B) enthalten ist.

5. Verfahren zur Herstellung der wärmeleitfähigen Siliconzusammensetzung nach einem der Ansprüche 1 bis 4, umfassend den Schritt von Zugeben und Mischen der Komponente (C) nach Mischen der Komponenten (A), (B) und (D) .

6. Verfahren zum Verbessern der Ausgabeeigenschaften und der Formbeständigkeit der wärmeleitfähigen Siliconzusammensetzung nach einem der Ansprüche 1 bis 4 durch Mischen eines wärmeleitfähigen faserförmigen anorganischen Füllstoffs (C) und eines wärmeleitfähigen sphärischen oder amorphen Füllstoffs (D) in ein flüssiges Organopolysiloxan, das durch ein Gemisch der Komponente (A) und der Komponente (B) dargestellt wird.

7. Verfahren zur Herstellung einer elektronischen Vorrichtung, umfassend die Schritte:
Ausgeben der wärmeleitfähigen Siliconzusammensetzung nach einem der Ansprüche 1 bis 4 aus einem Behälter, der mit der wärmeleitfähigen Siliconzusammensetzung gefüllt ist, und Aufbringen der wärmeleitfähigen Siliconzusammensetzung auf wenigstens entweder einen wärmeerzeugenden Teil oder einen wärmeabführenden Teil; und
Härten der wärmeleitfähigen Siliconzusammensetzung bei einer Temperatur von 15 °C oder höher.

## Revendications

1. Composition de silicone thermiquement conductrice ayant une contrainte de compression inférieure ou égale à 300 MPa et une capacité de rétention de forme supérieure ou égale à 90 % et
une viscosité initiale à 25 °C dans la plage de 50 000 mPa·s ou plus à 2 000 000 mPa·s ou moins, dans laquelle la contrainte de compression, la capacité de rétention de forme et la viscosité initiale sont mesurées comme indiqué dans la description, et comprenant :
un composant (A) qui est un diorganopolysiloxane ayant un groupe alcényle lié à un atome de silicium, ayant une viscosité, à 25 °C, de 10 mPa·s ou plus à 1 000 000 mPa·s ou moins, dans laquelle la viscosité est mesurée comme indiqué dans la description ;
un composant (B) qui est un diorganopolysiloxane ayant un atome d'hydrogène lié à un atome de silicium, ayant une viscosité, à 25 °C, de 10 mPa·s ou plus à 1 000 000 mPa·s ou moins ;
0,1 partie en masse ou plus et 5,0 parties en masse ou moins par rapport à 100 parties en masse de la composition de silicone entière d'un composant (C) qui est une charge inorganique fibreuse thermiquement conductrice qui est une fibre inorganique basique ;
75 parties en masse ou plus et 95 parties en masse ou moins par rapport à 100 parties en masse de la composition entière de silicone d'un composant (D) qui est une charge sphérique thermiquement conductrice ou une charge amorphe thermiquement conductrice
et comprenant un élément choisi dans le groupe constitué par l'hydroxyde d'aluminium, le nitrure de bore, le nitrure d'aluminium, l'oxyde de zinc, l'oxyde d'aluminium, l'oxyde de magnésium et l'hydroxyde de magnésium
ou étant un hydroxyde amphotère ou un oxyde amphotère ; et
un composant (E) qui est un catalyseur d'addition, dans laquelle la composition de silicone thermiquement conductrice est appropriée pour être appliquée à l'état liquide sur un substrat, sur lequel elle forme un réactif non fluide dans les 120 minutes suivant son application.

2. Composition de silicone thermiquement conductrice selon la revendication 1, dans laquelle la charge inorganique fibreuse thermiquement conductrice du composant (C) est du sulfate de magnésium basique.

3. Composition de silicone thermiquement conductrice selon l'une quelconque des revendications 1 à 2, dans laquelle la charge inorganique fibreuse thermiquement conductrice du composant (C) a un diamètre moyen de fibre de 0,1 µm ou plus et inférieur à 10 µm, et une longueur moyenne de fibre de 0,5 µm ou plus et de 200 µm ou moins.

4. Composition de silicone thermiquement conductrice selon l'une quelconque des revendications 1 à 3, dans laquelle la charge inorganique fibreuse thermiquement conductrice du composant (C) est contenue en une quantité de 1 partie en masse ou plus et 50 parties en masse ou moins par rapport à 100 parties en masse d'une quantité totale du composant (A) et du composant (B).

5. Procédé de production de la composition de silicone thermiquement conductrice selon l'une quelconque des revendications 1 à 4, comprenant l'étape d'addition et de mélange du composant (C) après le mélange des composants (A), (B) et (D).

6. Procédé pour améliorer les propriétés de distribution et la capacité de rétention de forme de la composition de silicone thermiquement conductrice selon l'une quelconque des revendications 1 à 4 en mélangeant une charge inorganique fibreuse thermiquement conductrice (C) et une charge sphérique ou amorphe thermiquement conductrice (D) dans un organopolysiloxane liquide représenté par un mélange du composant (A) et du composant (B).

7. Procédé de production d'un dispositif électronique comprenant les étapes de :
décharge de la composition de silicone thermiquement conductrice selon l'une quelconque des revendications 1 à 4 d'un récipient rempli avec la composition de silicone thermiquement conductrice et application de la composition de silicone thermiquement conductrice sur au moins soit une partie génératrice de chaleur, soit une partie dissipatrice de chaleur ; et
durcissement de la composition de silicone thermiquement conductrice à une température de 15 °C ou plus.
